# FASCICULE DE BREVET EUROPEEN

(11) **EP 0 326 777 B1**
(45) Date de publication et mention de la délivrance du brevet: **28.04.1993**
(21) Numéro de dépôt: 88420416.5
(22) Date de dépôt: 14.12.1988
(51) Int. Cl.: H01L 27/02, H02H 9/04

(54) **Structure de protection d'un accès à un circuit intégré**
Eingangsschutzstruktur für integrierte Schaltung
Access protection structure for integrated circuit

(30) Priorité: 14.12.1987 FR 8717781
(43) Date de publication de la demande: 09.08.1989
(73) Titulaire: SGS-THOMSON MICROELECTRONICS S.A., 94250 Gentilly (FR)
(72) Inventeur: Tailliet, François, F-93800 Epinay/Seine (FR); Gaultier, Jean-Marie, F-13790 Rousset sur Arc (FR)
(74) Mandataire: de Beaumont, Michel

(56) Documents cités:
- DE-A- 3 636 829
- DE-C- 2 257 846
- GB-A- 2 092 379
- US-A- 3 201 682

## Description

La présente invention concerne une structure de protection d'éléments reliés à un plot de circuit intégré. Plus particulièrement, la présente invention propose une telle structure présentant une résistance négative, c'est-à-dire se déclenchant pour une première valeur de surtension puis laissant ensuite s'écouler le courant de surcharge sous une deuxième tension de valeur plus faible.

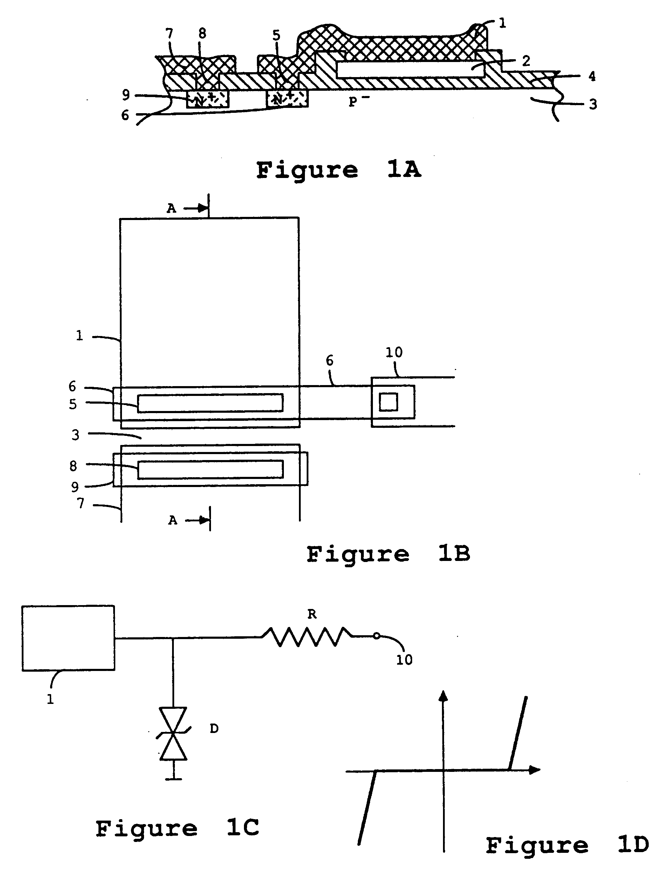

Les figures 1A, 1B et 1C représentent respectivement une vue en coupe, une vue de dessus et un schéma équivalent d'une protection classique de circuit intégré à l'encontre des surtensions. La figure 1A est une vue en coupe selon la ligne A-A de la figure 1B.

On peut voir en figure 1A un plot de contact d'un circuit intégré constitué par exemple d'une métallisation 1 formée sur une couche de silicium polycristallin 2 et isolé d'un substrat de silicium monocristallin 3 par une couche d'oxyde 4. Ce plot est en contact par une ouverture 5 avec une région 6 fortement dopée selon le type de conductivité opposé à celui du substrat, par exemple N⁺ si le substrat est de type P⁻. Une autre métallisation 7 est en contact par une autre ouverture 8 avec une autre région 9 de type N⁺ en regard de la région 6 comme on le voit mieux sur la vue de dessus de la figure 1B. Il existe donc ainsi entre la métallisation 1 du plot et la métallisation 7 reliée à la tension de référence une double diode à avalanche dont la tension de claquage est déterminée par les niveaux de dopage des zones N⁺ et P⁻.

La figure 1B représente avec les mêmes références que la figure 1A une vue de dessus de la structure. On peut y voir en outre que la région 6 dopée de type N⁺ et reliée au plot se prolonge vers une autre métallisation 10 qui est elle-même reliée à l'accès du circuit intégré avec lequel on souhaite que le plot 1 établisse un contact et que l'on souhaite protéger des surtensions.

Le schéma équivalent de cette structure est illustré en figure 1C. Le plot 1 est relié à la métallisation 10 par l'intermédiaire d'une résistance R correspondant à la résistance du prolongement de la région 6 et ce plot est relié à une tension de référence, couramment la masse, par l'intermédiaire d'une double diode à avalanche D correspondant à la structure N⁺P⁻N⁺.

Ce dispositif fonctionne de façon satisfaisante mais présente l'inconvénient que la tension sur le plot lors d'une surtension est limitée à la valeur de la tension de la double diode à avalanche qui doit elle-même être supérieure aux valeurs de fonctionnement normales des tensions appliquées au circuit. Il se produit donc une dissipation d'énergie néfaste dans la région correspondant à la double diode à avalanche d'où il résulte un échauffement du circuit. En effet, l'énergie dissipée est égale à la valeur de la tension d'avalanche multipliée par le courant circulant dans le dispositif de protection. Si cette valeur de tension est réduite, la dissipation d'énergie dans le substrat sera plus faible, le courant dissipé étant toujours sensiblement le même.

Un objet de la présente invention est de prévoir une structure de protection à résistance négative, qui se déclenche pour un seuil donné de diode à avalanche mais qui ensuite permet de faire chuter la tension à une valeur plus basse.

Un autre objet de la présente invention est de prévoir une structure particulièrement simple pour réaliser une telle fonction.

Pour atteindre cet objet ainsi que d'autres, la présente invention prévoit une structure de protection d'un accès à un circuit intégré relié à un plot susceptible de recevoir des surtensions, le circuit intégré étant formé dans un substrat d'un premier type de conductivité à faible niveau de dopage, ce substrat étant relié à une tension de référence, comprenant dans le substrat autour de la zone de plot, selon une configuration entourant au moins partiellement cette zone de plot une première région du premier type de conductivité à fort niveau de dopage elle-même formée dans une deuxième région du deuxième type de conductivité et au delà de la première région par rapport au plot une troisième région du deuxième type de conductivité en contract au moins partiel avec la deuxième région ; la métallisation du plot établit aussi un contact avec une portion de la surface de la première région et une deuxième métallisation relie la première région à la troisième à un emplacement tel que le chemin de courant entre, d'une part, la zone de contact entre la métallisation du plot et la première région et, d'autre part, la zone où la troisième région forme une jonction avec le substrat (correspondant à une diode à avalanche) passe par un trajet résistif dans l'une au moins des première ou troisième région.

Selon un autre aspect de la présente invention, il est prévu un circuit de protection d'un accès à un circuit intégré relié à un plot susceptible de recevoir des surtensions dans lequel le plot est relié à un potentiel de référence par l'intermédiaire d'un premier trajet comprenant un transistor et par un deuxième trajet comprenant une résistance en série avec une diode à avalanche et dans lequel la base du transistor et le point de jonction de la résistance et de la diode à avalanche sont connectés ensemble à l'accès à protéger du circuit intégré.

Ces objets, caractéristiques et avantages de la présente invention seront exposés plus en détail dans la description suivante de modes de réalisation particuliers faite en relation avec les figures jointes parmi lesquelles :
les figures 1A, 1B, 1C et 1D décrites précédemment, représentent respectivement une vue en coupe, une vue de dessus, un schéma équivalent et une courbe de fonctionnement d'une structure de protection de l'art antérieur ;
les figures 2A, 2B, 2C et 2D représentent respectivement une vue en coupe, une vue des dessus, un schéma équivalent et une courbe de fonctionnement d'une structure de protection selon un premier mode de réalisation de la présente invention ; et
les figures 3A, 3B, 3C et 3D représentent respectivement une vue en coupe, une vue de dessus, un schéma équivalent et une courbe de fonctionnement d'une structure de protection selon un deuxième mode de réalisation de la présente invention.

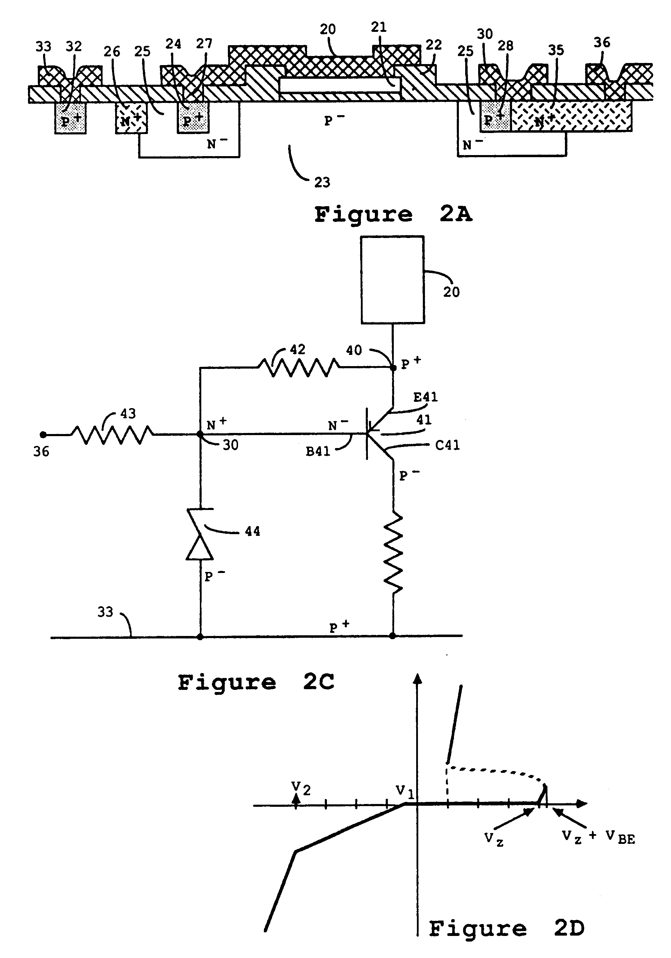

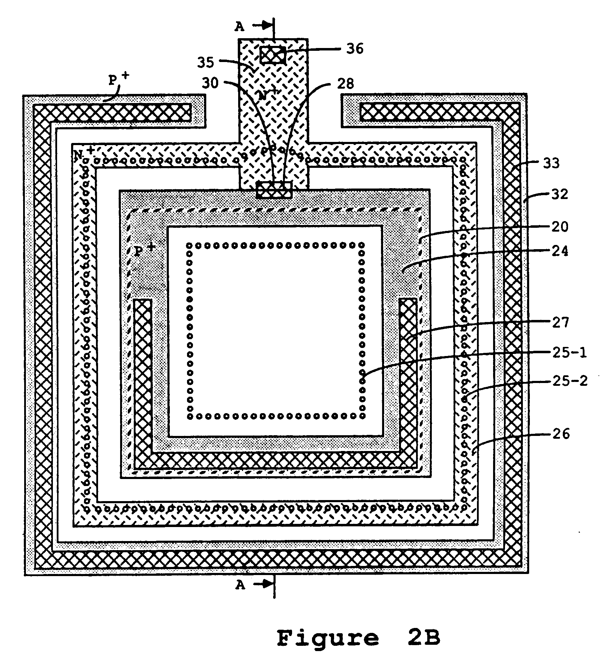

Les figures 2A et 2B auxquelles on se reférera simultanément ci-après représentent respectivement une vue en coupe et une vue de dessus schématiquement d'un premier mode de réalisation de la présente invention, la vue en coupe de la figure 2A étant prise selon la ligne A-A de la figure 2B.

La métallisation de plot 20 est représentée comme précédemment formée sur une couche de silicium polycristallin 21 (non représentée sur la vue de dessus de la figure 2B) et une couche d'isolement 22, couramment de l'oxyde de silicium au dessus d'un substrat de silicium monocristallin 23. Le contour de la métallisation est désigné par le trait en pointillés 20 de la figure 2B. Cette métallisation est en contact, par l'intermédiaire d'une ouverture 27, avec une partie d'une région de type P⁺ 24. Cette région 24 est elle-même formée dans une région 25 de type N⁻ dont les limites sont désignées en figure 2B par un succession de petits cercles portant les références 25-1 et 25-2. Une duexième région en anneau 26 de type N⁺ entoure la première région en anneau 24 et en est séparée par une largeur généralement constante de la région de type N⁻ 25, sauf en un emplacement 28 où les régions en anneaux de type P⁺ et N⁺ se rejoignent localement. La surface supérieure de la zone de fonction 28 entre les régions 24 et 26 est court-circuitée par une métallisation 30, seule l'ouverture de contact, également désignée par la référence 30, étant illustrée en figure 2B.

L'ensemble de la structure est entourée d'un anneau dopé de type P⁺ 32 revêtu d'une métallisation 33 permettant d'assurer la polarisation du substrat semiconducteur. La région 26 de type N⁺ comprend un prolongement 35 auquel est reliée une métallisation 36 dont seule l'ouverture de contact est représentée en figure 2B.

La structure illustrée en figure 2A et 2B correspond au schéma équivalent de la figure 2C. On retrouve dans ce schéma le plot 20, une borne se dirigeant vers le circuit à protéger correspondant à la métallisation 36, une borne de masse correspondant à la métallisation 33 et un point de raccordement correspondant à la métallisation 30.

La zone où le plot 20 est un contact avec l'anneau P⁺ 24 est désignée par la référence 40. Ce point 40 est représenté comme relié à l'émetteur E41 d'un transistor 41, cet émetteur correspondant à la région P⁺ 24. La base B41 correspond à la région N⁻ 25 et le collecteur C41 correspond à la région de substrat P⁻ et est relié à la masse par une résistance qui correspond au trajet dans la zone P⁻ vers la région diffusée de type P⁺ 32 et la métallisation 33. D'autre part, le point 40 est relié à une résistance 42, qui correspond au trajet dans la région P⁺ entre le contact 27 avec la métallisation de plot et le point de raccordement 30 qui correspond à la zone de court-circuit 28 entre cette région P⁺ et la région N⁺ 35. Ainsi, la métallisation 30 est reliée à la métallisation de sortie 36 par une résistance 43 correspondant au trajet dans la région N⁺ 35. Enfin, la métallisation 30 est reliée par une diode à avalanche 44 dont l'anode correspond à la région N⁺ 35 et la cathode à la région P⁻ de substrat qui est reliée, par une résistance de couche non représentée, à la région P⁺ 32 et à la métallisation 33.

Le fonctionnement de ce circuit va être exposé en relation avec la figure 2D qui représente la caractéristique courant-tension entre le plot et la borne de potentiel de référence.
- Dans le cas de l'application d'une surtension positive au plot 20 et au point 40, quand cette surtension atteint au point 30 la valeur V_{Z} de claquage de la diode 44, la croissance de la tension est limitée et le courant commence à passer dans la diode à avalanche 44. Très rapidement, cette circulation de courant amène la chute de tension aux bornes de la résistance 42 à dépasser la tension de conduction en direct V_{BE} de la jonction émetteur-base du transistor 41 ; ce transistor devient alors conducteur et le courant au lieu de passer dans la diode à avalanche 44 circule de l'émetteur au collecteur du transistor 41. Ainsi, comme le représente la figure, la tension au point 40 chute à la valeur BV_{CEO} de ce transistor. Pour donner des ordres de grandeur, la tension V_{Z} sera typiquement de l'ordre de 20 volts alors que la tension BV_{CEO} sera typiquement de l'ordre de quelques volts, par exemple 5 volts. On arrive donc à écouler le courant de surcharge sous une faible tension lors de l'apparition d'une surtension, ce qui entraîne une faible consommation d'énergie dans le substrat semiconducteur. Par contre, le dispositif ne se déclenche que pour la valeur relativement plus élevée de la tension d'avalanche de la diode 44 et ne nuit pas au fonctionnement normal du circuit.
- Dans le cas de l'application d'une surtension négative sur le plot 20, dès que l'on atteint une valeur V1 correspondant à la chute de tension en direct de la diode à avalanche 44, par exemple 1 volt, celle-ci commence à conduire. Ensuite, le courant passe dans la résistance 42 et la chute de tension aux bornes de cette résistance croît jusqu'à une valeur V2-V1 correspondant à la tension d'avalanche de la jonction base-émetteur du transistor 41 en inverse, c'est-à-dire également une valeur de l'ordre de 20 volts correspondant à la tension de claquage en inverse de la jonction P⁺N⁻ entre les régions 24 et 25. Ainsi, dans de cadre de ce fonctionnement en inverse, on a un fonctionnement sensiblement analogue à celui de l'art antérieur quand la surtension a atteint un niveau élevé mais avec l'avantage que la conduction commence plus tôt, dès la valeur V1 qui est une valeur faible ce qui n'est pas gênant pour l'absorption des surtensions en inverse car on se place dans le cas où le plot 20 est destiné à recevoir seulement des tensions positives et où donc toute tension négative correspond à un parasite.

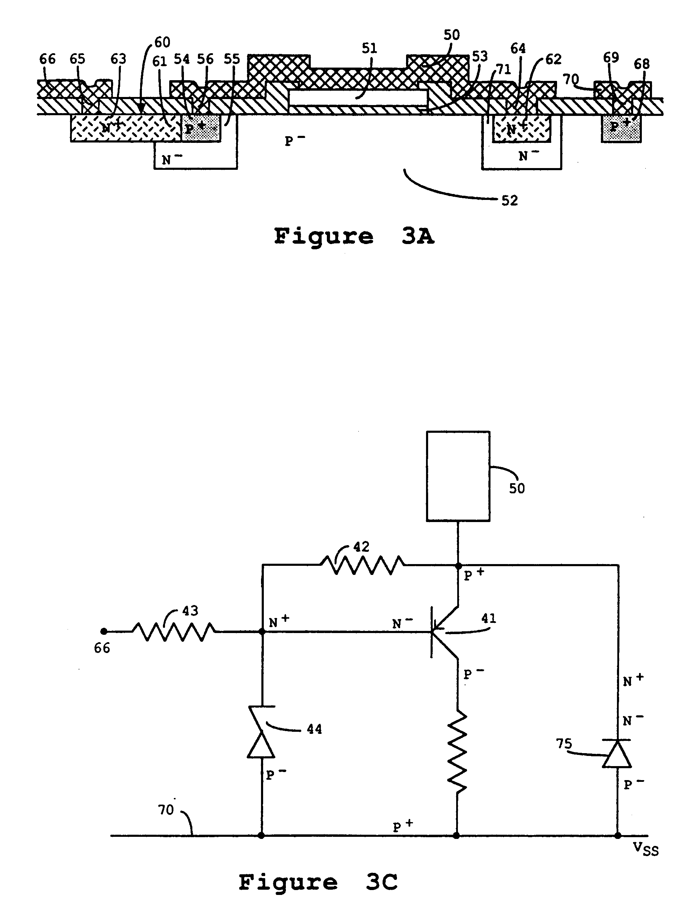

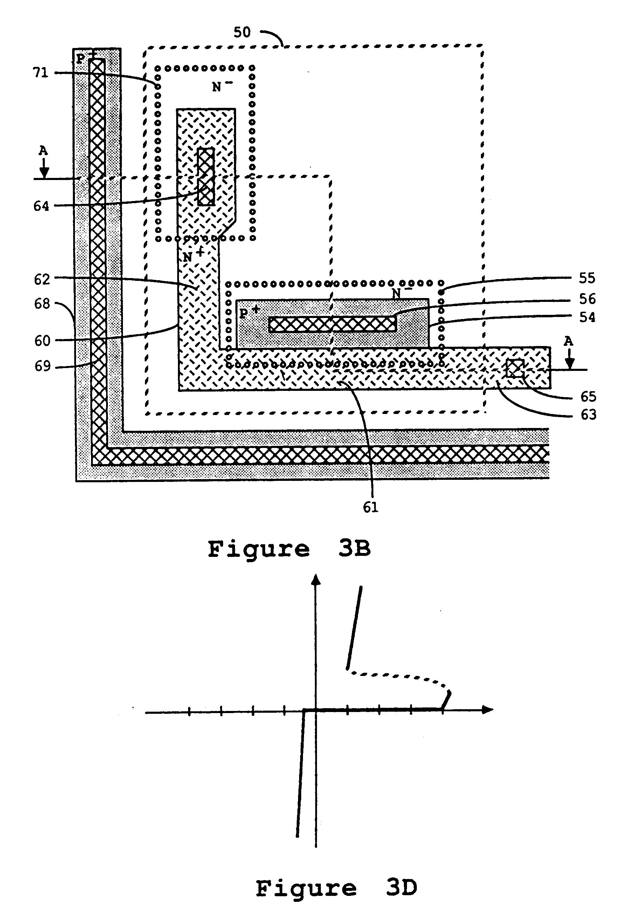

Les figures 3A, 3B, 3C et 3D représentent respectivement une vue en coupe, une vue de dessus, un schéma équivalent et une courbe de fonctionnement d'une variante de réalisation de la présente invention. La vue en coupe de la figure 3A correspond au tracé en pointillés désigné par A-A en figure 3B.

De façon générale, en considérant la figure 3B, on notera que la structure au lieu d'être une structure dans laquelle les diverses régions ont des formes en anneau est une structure dans laquelle les diverses régions longent un ou deux côtés de la zone de plot. Une telle structure pourrait aussi être adoptée dans le cas du mode de réalisation de la figure 1.

En se référant aux figures 3A et 3B, la variante de réalisation de l'invention qui est représentée comprend un plot métallique 50 susceptible de recevoir des surtensions, représenté comme dans le cas de la figure 2A sur une zone de silicium polycristallin 51 isolé d'un substrat 52 par une couche isolante 53, couramment de l'oxyde de silicium. De même que dans le cas de la figure 2B, on n'a pas représenté en figure 3B la zone de silicium polycristallin 51 et le contour de la métallisation 50 est désigné par un pointillé. La métallisation 50 est en contact avec une région diffusée de type P⁺ 54 formée dans une région diffusée N⁻ 55. On peut voir à la figure 3B que la région diffusée 54 et la région 55 dans laquelle elle est immergée s'étendent sensiblement le long d'un côté du plot 50. Une zone de contact 56 est prévue entre la zone de type P⁺ 54 et la métallisation de plot 50.

La région de type P⁺ 55 est en contact sensiblement sur toute sa longueur avec une région de type N⁺ 60 dans laquelle on peut distinguer trois parties : une partie 61 qui est précisément la partie en contact avec cette région de type P⁺, une partie 62 qui s'étend perpendiculairement à la première le long d'un autre côté du plot et une partie 63 qui prolonge la partie 61. La partie 62 de la région N⁺ 60 comprend vers son extrémité une zone de contact 64 avec la métallisation de plot 50. Le prolongement 63 de la région 60 type N⁺ comprend une zone de contact 65 reliée à une métallisation 66 vers l'accès à protéger du circuit intégré.

On a en outre représenté une région 68 de type P⁺ reliée par une zone de contact 69 à une métallisation de substrat 70. Couramment, cette métallisation sera reliée à un potentiel de référence tel que la masse. On notera en outre que la partie de la portion 62 de la région de type N⁺ 60 sur laquelle est formé le contact 64 est immergée dans une zone diffusée de type N⁻ 71. Comme dans le cas de la figure 2B, on a représenté en figure 3B les frontières des zones de type N⁻ 55 et 71 par des successions de petits cercles.

Le fonctionnement de la structure des figures 3A et 3B va être explicité en relation avec la figure 3C. On peut voir dans cette figure le plot 50, la métallisation de substrat 70 et la métallisation d'accès au circuit intégré 66. On retrouve dans cette figure le transistor 41 et la diode à avalanche 44 du schéma de la figure 3C. Comme précédemment, l'émetteur du transistor 41 correspond à la région P⁺ 54 reliée au plot 50, sa base correspond à la région N⁻ 55 et son collecteur correspond à la région de substrat 52 de type P⁻ elle-même reliée à la métallisation de référence 70 par la région de type P⁺ 68.

La diode à avalanche 44 correspond à la jonction entre le substrat de type P⁻ et la partie de la région de type N⁺ 60 qui n'est pas immergée dans la zone de type N⁻ 55 ou la zone de type N⁻ 62. On notera qu'il existe une liaison, au voisinage de la partie 61 entre cette région N⁺ et la région de type N⁻ 55 correspondant à la base du transistor 41. Cette fois ci, la résistance 42 entre la cathode correspondant à la région N⁺ 60 de la diode à avalanche et la zone de contact entre la région P⁺ et le plot est assurée par la résistance interne de la région 60 entre la région de contact 64 de la couche de type N⁺ 62 avec le plot 50 et la région de cette zone 60 où se trouve la diode à avalanche. Ainsi, contrairement au cas de la figure précédente, la résistance 42 est formée dans une région de type N⁺ au lieu d'une région de type P⁺. Néanmoins son effet est le même. En outre, comme, contrairement au cas du premier mode de réalisation, la région de type N⁺ 62 est connectée à la métallisation de plot 50, il apparaît une diode P⁺P⁻(N⁻)N⁺ entre la métallisation 70, la région 68, la région 52, la région 71, la région 62 et la métallisation 50. Cette diode est désignée par la référence 75 en figure 3C.

La courbe caractéristique courant-tension de ce circuit est illustrée par la figure 3D. Dans le cas d'une impulsion de surtension de sens positif, le fonctionnement est le même que dans le cas de la figure 2D. Par contre, dans le cas d'une impulsion négative, celle-ci est absorbée par la diode 75.

On notera que l'on pourra préférer le fonctionnement dans le sens négatif correspondant à celui de la figure 2D pour éviter le problème de latch-up bien connu des circuits CMOS et permettre d'éviter d'atteindre un seuil destructif.

## Revendications

1. Structure de protection d'un accès à un circuit intégré relié à un plot susceptible de recevoir des surtensions, le circuit intégré étant formé dans un substrat (23 ; 52) d'un premier type de conductivité à faible niveau de dopage, ce substrat étant relié à une tension de référence, la dite structure de protection comprenant dans le substrat, autour de la zone de plot et selon une configuration entourant au moins partiellement cette zone de plot :
- une première région (24 ; 54) du premier type de conductivité à fort niveau de dopage elle-même formée dans une deuxième région (25 ; 55) du deuxième type de conductivité, et
- au delà de la première région par rapport au plot une troisième région (26 ; 60) du deuxième type de conductivité en contact au moins partiel avec la deuxième région,
et dans laquelle :
- la métallisation (20 ; 50) du plot établit aussi un contact avec une portion (27 ; 56) de la surface de la première région,
- une deuxième métallisation (30 ; 50) relie la première région à la troisième à un emplacement tel que le chemin de courant entre, d'une part, la zone de contact entre la métallisation du plot et la première région et, d'autre part, la zone où la troisième région forme une jonction avec le substrat (correspondant à une diode à avalanche) passe par un trajet résistif dans l'une au moins des première ou troisième région.

2. Circuit de protection d'un accès à un circuit intégré relié à un plot susceptible de recevoir des surtensions, dans lequel le plot (20 ; 50) est relié à un potentiel de référence (33 ; 70) par l'intermédiaire d'un premier trajet comprenant un transistor (41) et par un deuxième trajet comprenant une résistance (42) en série avec une diode à avalanche (44), et dans lequel la base du transistor et le point de jonction de la résistance et de la diode à avalanche sont connectés ensemble à l'accès à protéger du circuit intégré.

3. Circuit selon la revendication 2, comportant en outre un troisième trajet comprenant une diode (75) connectée dans le sens direct entre la tension de référence (70) et le plot (50).

## Claims

1. A protection structure for an integrated circuit connected to a pad liable to receive overvoltages, the integrated circuit being formed in a substrate (23; 52) of a first conductivity type having a low doping level, this substrate being connected to a reference voltage, said protection structure comprising, in the substrate, around the pad area and according to a configuration surrounding at least partially this pad area:
- a first region (24; 54) of the first conductivity type having a high doping level, in turn formed in a second region (25; 55) of the second conductivity type, and
- beyond the first region with respect to the pad, a third region (26; 60) of the second conductivity type partially in contact at least with the second region;
and characterized in that:
- the pad metallization (20; 50) also establishes a contact with a portion (27; 56) of the first region surface,
- a second metallization (30; 50) connects the first region to the third one at such a location that the current path between, on the one hand, the contact area between the pad metallization and the first region and, on the other hand, the area where the third region forms a junction with the substrate (corresponding to an avalanche diode) follows a resistive path in at least one of the first or third region.

2. A protection circuit for an integrated circuit connected to a pad liable to receive overvoltages, characterized in that the pad (20; 50) is connected to a reference voltage (33; 70) through a first path comprising a transistor (41) and through a second path comprising a resistor (42) in series with an avalanche diode (44), and wherein the transistor base and the junction point of said resistor and said avalanche diode are interconnected to the integrated circuit access to be protected.

3. A circuit according to claim 2, further comprising a third path comprising a forward-connected diode (75) between the reference voltage (70) and the pad (50).

## Patentansprüche

1. Eingangsschutzstruktur für einen integrierten Schaltkreis, der mit einer Kontaktstelle verbunden ist, die Überspannungen empfangen kann, wobei der integrierte Schaltkreis in einem Substrat (23; 52) eines ersten Leitungstyps mit niedrigem Dotierungsniveau ausgebildet ist und das Substrat mit einer Referenzspannung verbunden ist, wobei die Schutzstruktur in dem Substrat um das Gebiet der Kontaktstelle herum in einer Anordnung, die mindestens teilweise dieses Gebiet der Kontaktstelle umgibt,
- einen ersten Bereich (24; 54) des ersten Leitungstyps mit hohem Dotierungsniveau, der selbst in einem zweiten Bereich (25; 55) des zweiten Leitungstyps ausgebildet ist, und
- bezüglich der Kontaktstelle jenseits des ersten Bereichs einen dritten Bereich (26; 60) des zweiten Leitungstyps, der zumindest teilweise mit dem zweiten Bereich in Kontakt steht,
enthält und bei dieser
- die Metallisierung (20; 50) der Kontaktstelle auch einen Kontakt mit einem Teil (27; 56) der Oberfläche des ersten Bereichs herstellt,
- eine zweite Metallisierung (30; 50) den ersten Bereich mit dem dritten an einer solchen Stelle verbindet, daß der Weg des Stroms zwischen dem Kontaktbereich zwischen der Kontaktstellenmetallisierung und dem ersten Bereich einerseits und dem Gebiet, wo der dritte Bereich einen Übergang mit dem Substrat bildet, (das einer Lawinendurchbruch-Diode entspricht) andererseits durch eine resistive Strecke in mindestens dem ersten oder dritten Bereich verläuft.

2. Eingangsschutzschaltkreis für einen integrierten Schaltkreis, der mit einer Kontaktstelle verbunden ist, die Überspannungen empfangen kann, bei dem die Kontaktstelle (20; 50) mit einem Referenzpotential (33; 70) über einen ersten Weg, der einen Transistor (41) enthält, und durch einen zweiten Weg, der einen Widerstand (42) in Reihe mit einer Lawinendurchbruch-Diode (44) enthält, verbunden ist und bei dem die Basis des Transistors und der Verbindungspunkt des Widerstands und der Lawinendurchbruch-Diode zusammen mit dem zu schützenden Eingang des integrierten Schaltkreises verbunden sind.

3. Schaltkreis nach Anspruch 2, der weiterhin einen dritten Weg umfaßt, der eine Diode (75) enthält, die in Vorwärtsrichtung zwischen der Referenzspannung (70) und der Kontaktstelle (50) geschaltet ist.
